# EUROPEAN PATENT APPLICATION

(11) **EP 4 726 552 A1**
(43) Date of publication of application: **15.04.2026**
(21) Application number: 25306501.5
(22) Date of filing: 18.09.2025
(51) Int. Cl.: G06F 11/1446, G05B 19/00, G05B 19/042, G05B 19/048

(54) **CONTROL DEVICE FOR AN ELECTRICAL LOAD, OPERATING METHOD AND CONTROL CABINET**

(30) Priority: 25.09.2024 CN 202411345090
(71) Applicant: SCHNEIDER ELECTRIC INDUSTRIES SAS, 92500 Rueil-Malmaison (FR)
(72) Inventor: SHUANG, Bing, Shanghai, 201203 (CN); YING, Xiaoping, Shanghai, 201203 (CN); BAI, Wanlong, Shanghai, 201203 (CN); LI, Zewei, Shanghai, 201203 (CN)
(74) Representative: Manitz Finsterwald Patent- und Rechtsanwaltspartnerschaft mbB

(57) **Abstract**

The present disclosure relates to a control device (100) for an electrical load (R), including: a stationary module fixedly arranged, wherein a backup unit (1011) is arranged in the stationary module; a replaceable movable module (102, 3012, 3022, 3032, 3042) configured to perform control of the electrical load (R) based on first operation data stored in the movable module (102, 3012, 3022, 3032, 3042), and to periodically backup the first operation data to the backup unit (1011) as second operation data. The present disclosure also relates to an operating method for a control device (100) of an electrical load (R) and a control cabinet for an electrical load (R).

## Description

### TECHNICAL FIELD

The present disclosure relates to the field of control devices, and in particular to a control device for an electrical load, an operating method and a control cabinet.

### BACKGROUND

In application scenarios with important electrical loads (such as motors), control devices connected to the electrical loads are often used to monitor and control the electrical loads to ensure the normal operation of the electrical loads. If the control device fails and needs to be replaced, the operation of the electrical load is interrupted at the same time for safety reasons. In order to avoid the safety risks and economic risks caused by long-term interruption of electrical loads, it is expected to achieve rapid replacement of control device.

During the replacement of the control device, not only the hardware needs to be replaced, but also the data related to the control of the electrical load or the operation of the control device needs to be restored in the control device.

### SUMMARY

Embodiments of the present disclosure provide a control device for an electrical load, an operating method and a control cabinet. By backing up operation data in a stationary module of the control device, it does not rely on the communication connection between the control device and external components and can realize timely backup and reliable recovery of operation data, which facilitates the management of operation data and greatly improves the reliability and safety of rapid replacement of control device.

Embodiments of the present disclosure provide a control device for an electrical load, comprising: a fixedly arranged stationary module, wherein a backup unit is arranged in the stationary module; a replaceable movable module configured to perform control of the electrical load based on first operation data stored in the movable module, and to periodically backup the first operation data to the backup unit as second operation data.

According to an embodiment of the present disclosure, the first operation data includes a plurality of parameter data, each parameter data correspondences to a different parameter category and including an index number, a data value and timeliness information, wherein the index number is configured to indicate the parameter category of the parameter data, the data value is configured to indicate the numerical value of the parameter data, and the timeliness information is configured to indicate whether the parameter data is the latest changed version.

According to an embodiment of the present disclosure, periodically backing up the first operation data to the backup unit as the second operation data includes: comparing the first operation data and the second operation data corresponding to timeliness information of parameter data of the same parameter category; backup parameter data with updated timeliness information in the first operation data into the backup unit.

According to an embodiment of the present disclosure, the movable module is further configured to back up the first operation data stored in the movable module into the backup unit as the second operation data in response to a user request.

According to an embodiment of the present disclosure, the movable module is further configured to read the second operation data stored in the backup unit and write it into the movable module as the first operation data.

According to an embodiment of the present disclosure, the backup unit is provided with a communication connection by the movable module.

According to an embodiment of the present disclosure, the first operation data is derived from at least one of the following: initial operation data of the control device; real-time operation data generated during control; configuration run data configured by a user; and the second operation data stored in the backup unit.

According to an embodiment of the present disclosure, a user configuration unit, a control unit and a local storage unit are arranged in the movable module: the user configuration unit is configured to receive the configuration run data and send it to the control unit; the control unit is configured to write the received operation data to the local storage unit as first operation data and to perform control of the electrical load based on the first operation data; and the local storage unit is configured to store the first operation data non-volatilely.

Embodiments of the present disclosure provide an operating method for a control device of an electrical load, the control device comprising a fixedly arranged stationary module and a replaceable movable module, a backup unit is arranged in the stationary module, the method includes: performing, by the movable module, control of the electrical load based on the first operation data stored in the movable module; and periodically backing up, by the movable module, the first operation data to the backup unit as second operation data.

According to an embodiment of the present disclosure, the method further includes: backing up, by the movable module, the first operation data stored in the movable module into the backup unit as the second operation data in response to a user request.

According to an embodiment of the present disclosure, the method further comprises, in response to the movable module being replaced with a replacement movable module, reading and writing, by the replacement movable module, the second operation data stored in the backup unit into the replacement movable module as the first operation data.

According to an embodiment of the present disclosure, the method further comprises reading and writing, by the movable module, second operation data stored in the backup unit into the movable module as the first operation data in response to a user request.

According to an embodiment of the present disclosure, the first operation data includes a plurality of parameter data, each parameter data corresponds to a different parameter category and includes an index number, a data value and timeliness information, wherein the index number is used to configured a parameter category of the parameter data, the data value is configured to indicate a numerical value of the parameter data, and the timeliness information is configured to indicate whether the parameter data is the most recently changed version, and wherein the periodically backing up the first operation data to the backup unit as the second operation data includes: comparing, by the movable module, the timeliness information of parameter data corresponding to the same parameter category in the first operation data and the second operation data; backing up, by the movable module, parameter data with updated timeliness information in the first operation data into the backup unit.

An embodiment of the present disclosure provides a control cabinet for an electrical load, comprising a plurality of control devices according to any of the embodiments of the present disclosure.

### BRIEF DESCRIPTION OF DRAWINGS

In order to explain the technical solutions of the embodiments of the present disclosure more clearly, the drawings needed to be used in the description of the embodiments will be briefly introduced below. Obviously, the drawings in the following description are only some exemplary embodiments of the present disclosure. For those of ordinary skill in the art, other drawings can be obtained based on these drawings without exerting creative efforts.
Fig. 1 illustrates a schematic diagram of a control device according to an embodiment of the present disclosure;
Fig. 2 illustrates a schematic diagram of a control device according to a further embodiment of the present disclosure;
Fig. 3 illustrates a schematic diagram of a control cabinet according to an embodiment of the present disclosure;
Fig. 4 illustrates a schematic diagram of an operating method for a control device of an electrical load according to an embodiment of the present disclosure.

### DETAILED DESCRIPTION

In order to make the purpose, technical solutions and advantages of the present disclosure more obvious, example embodiments according to the present disclosure will be described in detail below with reference to the accompanying drawings. Obviously, the described embodiments are only some of the embodiments of the present disclosure, but not all of the embodiments of the present disclosure. It should be understood that the present disclosure is not limited by the example embodiments described here.

In this specification and the drawings, substantially the same or similar steps and elements are denoted by the same or similar reference numerals, and repeated descriptions of these steps and elements will be omitted. Meanwhile, in the description of the present disclosure, the terms "first", "second", etc. are only used to distinguish descriptions and cannot be understood as indicating or implying relative importance or ranking.

Unless defined otherwise, all technical and scientific terms used herein have the same meaning as commonly understood by one of ordinary skill in the art to which this disclosure belongs. The terminology used herein is for the purpose of describing embodiments of the present invention only and is not intended to be limiting of the present invention.

For data management of control device, such as data backup and data recovery, in a mainstream solution, the operation data of the control device is periodically sent to a central control system external to the control device through bus communication. For example, operation data of multiple control devices are received and stored simultaneously. In the case where a control device is replaced with a new control device, the central control system identifies which control device was replaced and then sends the correspondingly stored operation data to the new control device. This solution relies on the communication of the central control system and the control device with the outside. The central control system needs to accurately identify the replaced control device and accurately match the operation data, reducing the reliability of data recovery and increasing the cost. The communication between the control device and the outside is greatly affected by bus communication. For example, a failure of any communication node (such as gateway, other control device) between the control device and the central control system will affect data management.

In another mainstream solution, data management is performed by means of an external dedicated mobile device. In this solution, the operation data of the control device needs to be periodically uploaded as a configuration file through dedicated software and saved in a dedicated mobile device. After replacing the new control device, the new control device is configured again by means of the dedicated mobile device. This solution cannot guarantee the timeliness of the saved operation data, and the configuration time is long, increasing the risk of power load interruption. In addition, the use of dedicated mobile devices increases management costs. If the operation data of one type of control device is incorrectly configured into another type of control device, it may cause the other type of control device to fail to operate normally or even malfunction.

In order to solve the above-mentioned problems in the prior art such as reliance on external communication, the need to accurately identify the control device or low timeliness of the managed operation data, high data management costs, and low reliability, the present disclosure provides a control device for an electrical load, an operation Method and a control cabinet, by backing up operation data in a stationary module of the control device, so that it does not rely on the communication connection between the control device and the outside, reduces the risk of data management failure due to communication failures, and does not need to identify specific control device, avoiding erroneous matching of operation data and control device. In addition, it can realize timely backup and reliable recovery of operation data, facilitate the management of operation data, and greatly improve the reliability and safety of rapid replacement of especially control device.

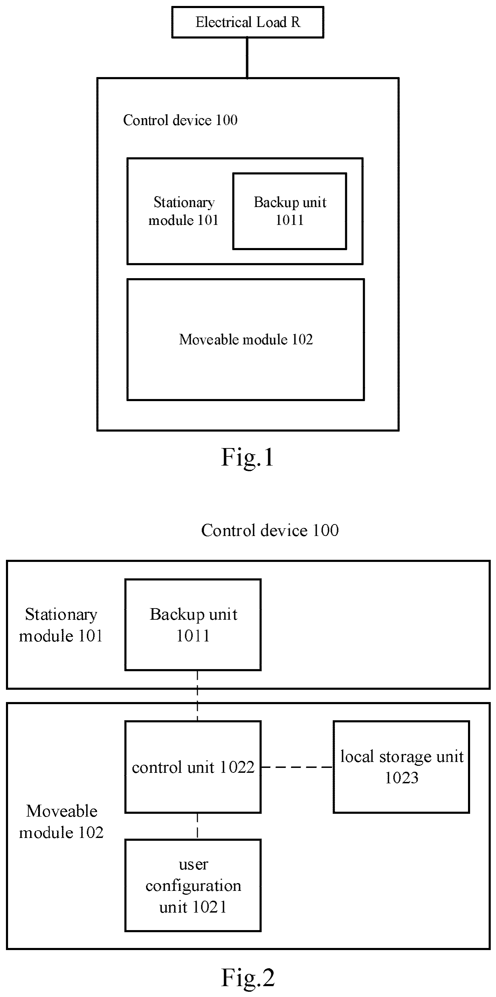

FIG. 1 illustrates a schematic diagram of a control device according to an embodiment of the present disclosure.

As shown in Fig. 1, a control device 100 for an electrical load R according to an embodiment of the present disclosure can for example comprise a fixedly arranged stationary module 101 and a replaceable movable module 102.

An electrical load R, e.g. a motor, is connected to the control device 100, e.g. downstream. When the electric load R is a motor, the control device 100 can be, for example, a motor protector in a motor control center (MCC), which is used to disconnect the power supply or reduce the motor current promptly to protect the control circuit to prevent motor damage, thereby protect the safety of the motor and circuit, when the motor fails such as overcurrent, overheating, motor overload, etc..

For example, a backup unit 1011 can be arranged in the stationary module 101. The backup unit 1011 is, for example, configured to store data and can be designed as a nonvolatile storage device such as a USB disk. Compared with using an external mobile storage device for data backup, the backup unit 1011 arranged in the stationary module 101 avoids the risk that the backed-up operation data does not match the control device and the power consumption load when restoring.

In addition to the backup unit 1011, other components for supporting the normal operation of the control device 100 can also be arranged in the stationary module 101, such as a power distribution unit, a communication unit, etc., to provide the control device 100 with power supply, communication connection with the bus, and communication connection with electrical load R, etc.

The movable module 102 can, for example, be configured to perform control of the power consumption load R based on the first operation data stored in the movable module 102, and periodically backup the first operation data to the backup unit 1011 as the second operation data.

In some embodiments, the control device 100 is a drawer-style control device. The stationary module 101 is, for example, a fixedly arranged backplate part of a drawer-type control device, and the movable module 102 is, for example, a replaceable drawer part of the drawer-type control device. Accordingly, in the event of a failure of the movable module 102, the movable module 102 can be easily and quickly replaced.

The movable module 102 performs control of the electrical load R based on the first operation data. The first operation data can include, for example, a plurality of parameter data.

The amount of parameter data and parameter categories vary depending on the control device. Taking the control device 100 as a motor protector as an example, the parameter category can be related to operation protection, such as the rated current and power of the motor; parameter categories can also be related to communication connections, such as setting parameters for gateways; parameter categories can also be related to energy management, such as motor running time and energy consumption; or the parameter category can also be related to maintenance information, such as motor fault information.

For example, in the case of replacing a new movable module 102, it therefore makes sense that the new movable module 102 simply and quickly obtains the operation data of the old movable module 102, which not only eliminates the need to reconfigure the parameter data in the new movable module, but also obtains historical information about the control of the electric load R.

According to embodiments of the present disclosure, each parameter data corresponds to a different parameter category and can include an index number, a data value, and timeliness information, for example.

The index number can be used to indicate the parameter category of the parameter data. For example, the index number of the first parameter data is "1", which is used to indicate that the parameter category of the first parameter data is rated current; the index number of the second parameter data is "2", which is used to indicate that the parameter category of the second parameter data is energy consumption. An unambiguous correspondence between the parameter data and the corresponding parameter type is achieved using the index number.

Data values can be used to indicate the numerical value of parameter data. For example, the data value of the first parameter data for the parameter category of rated current can be 5 or 5A, and the data value of the second parameter data for the parameter category of energy consumption can be 100. Data values can be with or without units, depending on usage requirements.

Timeliness information can be used to indicate whether the parameter data is the most recently changed version. The movable module 102 performs the control of the electrical load R based on the first operation data, some parameter data of which (e.g. rated current of the electrical load R) do not change without user intervention, and some parameter data of which (e.g. operating time, energy consumption of the electrical load R) vary in real time. The movable module 102 periodically backs up the first operation data to the backup unit 1011 as the second operation data, wherein, compared with the real-time first operation data, there can be a parameter data that has not been the latest changed version of the second operation data stored in the backup unit 1011. Using timeliness information to indicate whether the parameter data is the latest changed version is beneficial to synchronize the first operation data and the second operation data.

For example, the timeliness information can be a timestamp of the last change to the parameter data. Advantageously, the timeliness information can also be a counter number. For example, every time the parameter data changes, the counter number increases, and in this way, the timeliness information can be distinguished.

According to an embodiment of the present disclosure, periodically backing up the first operation data by the movable module 102 to the backup unit 1011 as the second operation data includes comparing parameter data corresponding to the same parameter category in the first operation data and the second operation data. Timeliness information, and backing up the parameter data with updated timeliness information in the first operation data to the backup unit 1011.

For example, in one embodiment, the movable module 102 backs up the first parameter data corresponding to the first parameter category in the first operation data to the backup unit 1011 as part of the second operation data, and the most recent change of the first parameter data occurs at the first time point, i.e., the timeliness information is the first time point, so that the timeliness information of the backed-up first parameter data corresponding to the first parameter category in the second operation data is also the first time point. At the subsequent second time point, compared with the first time point, if the first parameter data in the first operation data has not changed, the timeliness of the first parameter data is still the first time point, which is the same as the timeliness information of the backed-up first parameter data in the second operation data; if the first parameter data in the first operation data has been changed at the third time point (earlier than the second time point and later than the first time point), the timeliness information of the first parameter data becomes the third time point, which is different from the timeliness information of the backed-up first parameter data in the second operation data, more specifically, the timeliness information of the first parameter data is updated. Subsequently, the movable module 102 backs up the first parameter data with the updated timeliness information into the backup unit 1011.

Advantageously, the parameter data can further comprise check value information for performing an integrity check, e.g. a cyclic redundancy check, on the parameter data in order to improve the reliability of data backup and data recovery. According to an embodiment of the present disclosure, the movable module 102 is further configured to read and write the second operation data stored in the backup unit 1011 into the movable module 1011 as the first operation data.

For example, in one embodiment, the movable module 102 is a replacement movable module that replaces the previous movable module, since the first operation data of the previous movable module is periodically stored in the backup unit 1011 of the stationary module 101 as the second operation data before the replacement, the backup unit 1011 has the operation data of the latest or newer previous movable module stored therein. The replacement movable module can be, for example, a completely new movable module, and can have first operation data derived from initial operation data, which can be preset with a specific value or zero value by the user, but it should be understood that the timeliness information of the first operation data derived from the initial operation data is earlier than the timeliness information of the second operation data in the backup unit 1011, i.e., the timeliness information of the second operation data is updated. The replacement movable module can also be, for example, a previously used movable module, but it should be understood that with the use of the previous movable module, the timeliness information of the first operation data stored in the replacement movable module should also be earlier than the timeliness information of the second operation data in the current backup unit 1011, i.e., the timeliness information of the second operation data is updated. In this case, the replacement movable module reads the second operation data stored in the backup unit 1011 and writes it into the replacement movable module as the first operation data, realizing rapid configuration of the replacement movable module.

By comparing the timeliness information of the parameter data corresponding to the same parameter category in the first operation data and the second operation data, it is possible to know which parameter data is updated, and the synchronization of the first operation data and the second operation data to the latest changed version can be achieved simply and effectively.

According to an embodiment of the present disclosure, the movable module 102 is further configured to back up the first operation data stored in the movable module 102 into the backup unit 1011 as the second operation data in response to a user request. In this way, the first operation data is backed up as the second operation data according to user needs. For example, backups can be performed when the next backup time point of periodic backups has not yet arrived so that movable modules can be replaced, etc., which improves the flexibility of data management.

According to an embodiment of the present disclosure, the backup unit 1011 is provided with a communication connection by the movable module 102, such as through a two-wire serial bus interface, a serial peripheral interface, etc. In this way, reliance on communications outside the control device 100 is advantageously avoided, so that even if communications outside the control device 100, such as bus communications, fail, for example due to intermediate nodes being disconnected, normal management of data, such as data backup and data recovery, can be achieved.

Fig. 2 illustrates a schematic diagram of a control device according to a further embodiment of the present disclosure. FIG. 2 and the embodiment are described below based on FIG. 1.

As shown in FIG. 2, for example, the movable module 102 can be arranged with a user configuration unit 1021, a control unit 1022 and a local storage unit 1023.

As described above, the movable module 102 is, for example, configured to perform control of the electrical load R based on the first operation data stored in the movable module 102. The first operation data can originate, for example, from at least one of the following:
- Initial operation data of the control device 100;
- real-time operation data generated during control;
- configuration run data configured by a user; and
- the second operation data stored in the backup unit 1011.

For example, before using the control device 100, the movable module 102 of the control device 100 has been configured with initial operation data as the first operation data, so that the control device 100 can be used after installation without backup second operation data. For example, in the initial operation data, the index number of the first parameter data whose the parameter category is rated current is "1", the data value is "5", and the timeliness information is "0", and the index number of the second parameter data whose the parameter category is energy consumption is "2", the data value is "0", the timeliness information is "0", etc.

After the operation of the control device 100, as the electrical load is controlled, real-time operation data can be generated during control. For example, the index number of the second parameter data whose parameter category is energy consumption is "2", a data value is "100", and timeliness information is "1".

Additionally, the operation data can be configured by the user. For example, if the user wishes to configure the first parameter data whose parameter category is rated current to a data value of 10, the corresponding configuration operation data is written into the first operation data to overwrite the original data value of the first parameter data and update the timeliness information at the same time.

Additionally, in the case where the movable module 102 is replaced with a replacement movable module, the second operation data stored in the backup unit 1011 can be read and written into the replacement movable module by the replacement movable module as the first operation data, in order to achieve rapid configuration of the replacement movable module.

Therefore, at least one of the initial operation data of the control device 100, the real-time operation data generated during control, the configuration operation data configured by the user, and the second operation data stored in the backup unit 1011 can constitute the first operation data of the movable module 102, and the movable module 102 performs control based on the first operation data.

The first operation data can include, for example, data related to the control of the electrical load and the operation of the control device.

According to an embodiment of the present disclosure, the user configuration unit 1021 can be configured to receive configuration operation data (or user request) configured by the user and send it to the control unit 1022. The user configuration unit 1021 can be designed as a human-machine interface (HMI), for example, so that users can perform data configuration through input devices such as screens and buttons, and can display data information and operation information of the control device and electrical loads.

According to an embodiment of the present disclosure, the control unit 1022 can be configured to write received operation data (e.g., configuration operation data, second operation data stored in the backup unit, real-time operation data generated during control) to the local storage unit 1023 as first operation data, and configured to perform control of the power consumption load based on the first operation data, for example, using internal control software. The control unit 1022 can be designed as a micro control unit (MCU), for example.

According to an embodiment of the present disclosure, the local storage unit 1023 can be configured to store the first operation data non-volatilely. The local storage unit 1023 writes data as the first operation data by the control unit 1022 and reads the first operation data by the control unit 1022 to perform control.

Utilizing the control device according to the embodiment of the present disclosure does not rely on the communication connection between the control device and the outside, which is beneficial to the reliability and security of data management. In the normal operation of a control device, real-time backup of operation data is realized. In the case of replacing movable module, parameter data setting and debugging of the new movable module need not spend a lot of time. The control device and electric load can resume normal operation quickly, saving economic cost and improving operation reliability. In addition, the backed-up second operation data is stored in the stationary module and does not rely on external software and hardware for data management, which saves costs and avoids the risk of the backed-up operation data not matching the control device and power load during recovery, and not only saves management costs but further improves operational reliability.

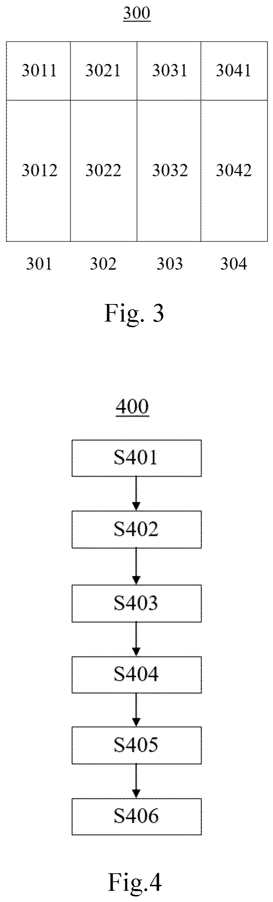

Fig. 3 illustrates a schematic diagram of a control cabinet according to an embodiment of the present disclosure.

The control cabinet 300 can be designed, for example, as a control system for centralized control of a series of electrical loads, such as a motor control center.

As shown in FIG. 3, the control cabinet 300 can include, for example, a plurality of control devices according to one of the embodiments of the present disclosure, here four control devices 301, 302, 303 and 304. The four control devices 301, 302, 303 and 304 do not need to be designed identically, but can be designed in aspects such as power interface, communication interface, parameter category, etc. according to the electrical load corresponding to each control device. Each control device can correspond to a different electrical load, or two or more control devices can be used for the same electrical load.

The control devices 301, 302, 303 and 304 comprise fixedly arranged stationary modules 3011, 3021, 3031, 3041 and replaceable movable modules 3012, 3022, 3032 and 3042, respectively. For example, in case the control device is designed as a drawer-type control device, the movable modules 3012, 3022, 3032 and 3042 are respectively drawer parts.

According to an embodiment of the present disclosure, the stationary modules 3011, 3021, 3031, and 3041 can be fixedly arranged at the cabinet body of the control cabinet 300, for example.

Utilizing the control cabinet according to the embodiment of the present disclosure does not rely on the communication connection between the control device and the outside, which is beneficial to the reliability and security of data management. In the normal operation of control device, real-time backup of operation data is realized. In the case of replacing an movable module, parameter data setting and debugging of the new movable module need not spend a lot of time. The control device and electric load can resume normal operation quickly, saving economic cost and improving operation reliability. In addition, the backed-up second operation data is stored in the stationary module and does not rely on external software and hardware for data management, which saves costs and avoids the risk of the backed-up operation data not matching the control device and power load when restored., not only saving management costs but further improving operational reliability.

Fig. 4 illustrates a schematic diagram of an operating method for a control device of an electrical load according to an embodiment of the present disclosure.

As shown in FIG. 4, the operating method 400 for a control device of an electrical load can include, for example, one or more of steps S401 to S406. The control device is, for example, the control device according to one of the embodiments of the present disclosure.

In step S401, control of the electrical load can be performed, e.g. by the movable module, based on the first operation data stored in the movable module.

In step S402, for example, the first operation data can be periodically backed up by the movable module to the backup unit as the second operation data. The period can be set as desired, such as 5 seconds, 1 minute, 1 hour, etc. With this method step, operation data for the control of the electrical load is backed up online and promptly. In response, the backup unit can store the second operation data. In this way, even if the movable module of the control device is replaced, the time-effective latest or newer second operation data is saved in the stationary module, facilitating the quick configuration of the new replacement movable module, and the backup unit is matched with the control device and the power consumption load, greatly reducing the management cost of the backup unit and the saved second operation data. According to embodiments of the present disclosure, multiple sets of second operation data with different time-effectiveness information can be stored in the backup unit, so that it is advantageously possible to select which set of second operation data to use.

In step S403, for example, the first operation data stored in the movable module can be backed up into the backup unit as the second operation data by the movable module in response to a user request. Using this method step, the first operation data is backed up as the second operation data according to user needs. For example, backups can be performed when the next backup time point of periodic backups has not yet arrived so that movable modules can be replaced, etc., which improves the flexibility of data management.

In step S404, the second operation data stored in the backup unit can be read and written by the replacement movable module into the replacement movable module as the first operation data, for example in response to the movable module being replaced with the replacement movable module. According to embodiments of the present disclosure, this method step can be performed automatically or in response to a user request, such as by the user clicking a "data recovery" button after replacing the movable module with a replacement movable module. The method can realize data configuration of replacement movable module simply, quickly and reliably, ensure normal operation of replacement movable module while realizing fast recovery of operation data of replacement movable module, shorten interruption time of control device and electric load, and improve reliability of control of electric load by control device.

In step S405, for example, the second operation data stored in the backup unit can be read and written into the movable module as the first operation data by the movable module in response to a user request. With this method step, for example, when the current first operation data in the movable module does not meet expectations, an older version of the second operation data can be read as the first operation data.

In step S406, for example, the movable module can compare the timeliness information of the parameter data corresponding to the same parameter category in the first operation data and the second operation data. Then, the parameter data with updated timeliness information in the first operation data is backed up by the movable module into the backup unit, or the parameter data with updated timeliness information in the second operation data is restored by the movable module into the movable module. Using this method step, synchronization of the first operation data and the second operation data is achieved. In addition, only backing up parameter data with updated timeliness information can save backup time and computing costs.

According to embodiments of the present disclosure, configuration operation data can be input by a user, for example. The user input of the configuration operation data may take place with the movable module installed in the control device or with the movable module not yet installed in the control device. For example, the user configuration is performed before the replacement movable module is installed in the control device, further reducing the time that the replacement movable module comes online. In this way, the flexibility of data management of the control device is increased. According to embodiments of the present disclosure, the operating method of a control device for an electrical load and its method steps can be performed in different modes, such as a manual mode (or upon user request) or an automatic mode. For example, in the automatic mode, if the movable module is replaced with a replacement movable module, after the replacement movable module is installed, the replacement movable module automatically reads and writes the second operation data stored in the backup unit into the replacement movable module as the first operation data, so that the replacement movable module can come online quickly.

It should be noted that the method flow shown in Fig. 4 is only schematic. In an alternative implementation, the method steps marked in the blocks may also occur in a different order than those marked in the drawings or some of the method steps may not occur at all. For example, two blocks shown in succession may, in fact, be executed substantially concurrently, or the blocks may sometimes be executed in the reverse order, depending upon the functionality involved.

For example, in case the operating method of a control device for an electrical load is performed in an automatic mode, in normal operation of the control module, the operating method performs the method steps S401, S402 and S406 in parallel, so that a reliable backup of the movable module and a synchronization of the first and second operation data is achieved, in response to replacing the movable module with a replacement movable module, the method step S404 is performed, enabling a fast online of the replacement movable module, when the movable module needs to be replaced, for example due to a malfunction. As another example, if the user has no need to actively back up the first operation data in addition to periodic backups, step S403 may not occur.

It will also be noted that each block of the block diagrams and/or flowchart illustration, and combinations of blocks in the block diagrams and/or flowchart illustration, can be implemented by special purpose hardware-based systems that perform the specified functions or operations, or combinations of special purpose hardware and computer instructions.

The embodiments and advantages of the operating method of a control device for an electrical load according to the present disclosure apply equally to the control device according to the present disclosure and the control cabinet according to the present disclosure, and vice versa.

Utilizing the operating method of the control device for the electrical load according to the embodiment of the present disclosure does not rely on the communication connection between the control device and the outside, which is beneficial to the reliability and security of data management. In the normal operation of a control device, real-time backup of operation data is realized. In the case of replacing an movable module, parameter data setting and debugging of the new movable module need not spend a lot of time. The control device and electric load can resume normal operation quickly, saving economic cost and improving operation reliability. In addition, the backed-up second operation data is stored in the stationary module and does not rely on external software and hardware for data management, which saves costs and avoids the risk of the backed-up operation data not matching the control device and power load when restored., not only saving management costs but further improving operational reliability.

Generally speaking, various example embodiments of the present disclosure can be implemented in hardware or special purpose circuits, software, firmware, logic, or any combination thereof. Some aspects can be implemented in hardware, while other aspects can be implemented in firmware or software which can be executed by a controller, microprocessor or other computing device. While aspects of embodiments of the disclosure are illustrated or described as block diagrams, flow charts, or using some other pictorial representation, it will be understood that the blocks, apparatus, systems, techniques or methods described herein can be implemented, as non-limiting examples, in hardware, software, firmware, special purpose circuits or logic, general purpose hardware or controller or other computing devices, or some combination thereof.

The example embodiments of the present disclosure described in detail above are illustrative only and not restrictive. It will be understood by those skilled in the art that various modifications and combinations can be made to these embodiments or features thereof without departing from the principles and spirit of the present disclosure, and such modifications should fall within the scope of the present disclosure.

## Claims

1. A control device (100) for an electrical load (R), **characterized in that** the control device (100) comprises:
- a fixedly arranged stationary module (101, 3011, 3021, 3031, 3041), wherein a backup unit (1011) is arranged in the stationary module (101, 3011, 3021, 3031, 3041);
- a replaceable movable module (102, 3012, 3022, 3032, 3042), which is configured to perform control of the electrical load (R) based on first operation data stored in the movable module (102, 3012, 3022, 3032, 3042), and to periodically back up the first operation data to the backup unit (1011) as second operation data.

2. The control device (100) according to claim 1, **characterized in that**
the first operation data comprises a plurality of parameter data, each of the plurality of parameter data correspondences to a different parameter category and comprises an index number, a data value and timeliness information, wherein,
the index number is configured to indicate a parameter category of each of the plurality of parameter data, respectively,
the data value is configured to indicate a numeric value of each of the plurality of parameter data, respectively, and
the timeliness information is configured to indicate whether each of the plurality of parameter data is the latest changed version, respectively.

3. The control device (100) according to claim 2, **characterized in that**
periodically backing up the first operation data to the backup unit (1011) as a second operation data comprises:
comparing the timeliness information of parameter data of the plurality of parameter data that correspond to the same parameter category in the first operation data and the second operation data;
backing up parameter data of the plurality of parameter data with updated timeliness information in the first operation data into the backup unit (1011).

4. The control device (100) according to claim 2, **characterized in that**
the movable module (102, 3012, 3022, 3032, 3042) is further configured to back up the first operation data stored in the movable module (102, 3012, 3022, 3032, 3042) into the backup unit (1011) as the second operation data in response to a user request.

5. The control device (100) according to claim 2, **characterized in that**
the movable module (102, 3012, 3022, 3032, 3042) is further configured to read the second operation data stored in the backup unit (1011) and write it into the movable module (102, 3012, 3022, 3032, 3042) as the first operation data.

6. The control device (100) according to claim 1, **characterized in that**
the backup unit (1011) is provided with a communication connection by the movable module (102, 3012, 3022, 3032, 3042).

7. The control device (100) according to claim 1, **characterized in that** the first operation data is derived from at least one of the following:
initial operation data of the control device (100);
real-time operation data generated during control;
configuration run data configured by a user; and
the second operation data stored in the backup unit (1011).

8. The control device (100) according to claim 7, **characterized in that**
a user configuration unit (1021), a control unit (1022) and a local storage unit (1023) are arranged in the movable module (102, 3012, 3022, 3032, 3042):
- the user configuration unit (1021) is configured to receive the configuration run data and transmit it to the control unit (1022);
- the control unit (1022) is configured to write the received operation data to the local storage unit (1023) as the first operation data and to perform control of the electrical load (R) based on the first operation data; and
the local storage unit (1023) is configured to store the first operation data non-volatilely.

9. An operating method for a control device (100) of an electrical load (R), **characterized in that**
the control device (100) comprises a fixedly arranged stationary module (101, 3011, 3021, 3031, 3041) and a replaceable movable module (102, 3012, 3022, 3032, 3042), a backup unit (1011) is arranged in the stationary module (101, 3011, 3021, 3031, 3041), the method comprises:
performing, by the movable module (102, 3012, 3022, 3032, 3042), control of the electrical load (R) based on the first operation data stored in the movable module (102, 3012, 3022, 3032, 3042); and
periodically backing up, by the movable module (102, 3012, 3022, 3032, 3042), the first operation data to the backup unit (1011) as second operation data.

10. The method of claim 9, **characterized in that** the method further comprises:
backing up, by the movable module (102, 3012, 3022, 3032, 3042), the first operation data stored in the movable module (102, 3012, 3022, 3032, 3042) into the backup unit (1011) as the second operation data in response to a user request.

11. The method of claim 9, **characterized in that** the method further comprises:
in response to the movable module (102, 3012, 3022, 3032, 3042) being replaced with a replacement movable module (102, 3012, 3022, 3032, 3042), reading and writing, by the replacement movable module (102, 3012, 3022, 3032, 3042), the second operation data stored in the backup unit (1011) into the replacement movable module (102, 3012, 3022, 3032, 3042) as the first operation data.

12. The method of claim 9, **characterized in that** the method further comprises:
reading and writing, by the movable module (102, 3012, 3022, 3032, 3042), the second operation data stored in the backup unit (1011) into the movable module (102, 3012, 3022, 3032, 3042) as the first operation data in response to a user request.

13. The method of claim 9, **characterized in that**
the first operation data comprises a plurality of parameter data, each of the plurality of parameter data correspondences to a different parameter category and comprises an index number, a data value, and timeliness information, wherein,
the index number is configured to indicate a parameter category of each of the plurality of parameter data, respectively,
the data value is configured to indicate a numeric value of each of the plurality of parameter data, respectively, and
the timeliness information is configured to indicate whether each of the plurality of parameter data is the latest changed version, respectively,
and wherein periodically backing up the first operation data to the backup unit (1011) as second operation data comprises:
comparing, by the movable module (102, 3012, 3022, 3032, 3042), the timeliness information of parameter data of the plurality of parameter data that correspond to the same parameter category in the first operation data and the second operation data;
backing up, by the movable module (102, 3012, 3022, 3032, 3042), parameter data of the plurality of parameter data with updated timeliness information in the first operation data into the backup unit (1011).

14. A control cabinet for an electrical load (R), **characterized in that**
the control cabinet comprises a plurality of control devices (100) according to any one of claims 1 to 8.
